# EUROPEAN PATENT APPLICATION

(11) **EP 4 723 162 A1**
(43) Date of publication of application: **08.04.2026**
(21) Application number: 24815312.4
(22) Date of filing: 21.05.2024
(51) Int. Cl.: H01L 21/205, H01L 21/20

(54) **METHOD FOR MANUFACTURING NITRIDE SEMICONDUCTOR SUBSTRATE, METHOD FOR MANUFACTURING HYBRID IC, AND NITRIDE SEMICONDUCTOR SUBSTRATE**

(30) Priority: 01.06.2023 JP 2023090721
(71) Applicant: Shin-Etsu Handotai Co., Ltd., Tokyo 100-0004 (JP)
(72) Inventor: HAGIMOTO Kazunori, Annaka-shi, Gunma 379-0196 (JP); TSUCHIYA Keitaro, Annaka-shi, Gunma 379-0196 (JP); SUGAWARA Kosei, Nishishirakawa-gun, Fukushima 961-8061 (JP)
(74) Representative: Schicker, Silvia
(86) International application number: PCT/JP2024/018747
(87) International publication number: WO 2024/247828

(57) **Abstract**

The present invention is a method for producing a nitride semiconductor substrate, the nitride semiconductor substrate including a group III-nitride layer that includes a group III-nitride base layer and a gallium nitride epitaxial layer on a Si substrate, in which a Si{110} substrate is employed, and the method includes the steps of performing a pre-flow by supplying a gas containing an Al raw material and not containing a nitrogen raw material onto the Si substrate being heated to a temperature of 1000°C or higher, forming a base layer to form a group III-nitride base layer on the Si substrate by supplying a gas containing a group III raw material and the nitrogen raw material, and forming an epitaxial layer to form a gallium nitride epitaxial layer by supplying a gas containing a Ga raw material and the nitrogen raw material. This provides the method for producing a nitride semiconductor substrate, in which the Si {110} substrate is employed, and the gallium nitride epitaxial layer having excellent surface morphology is provided.

## Description

### TECHNICAL FIELD

The present invention relates to a method for producing a nitride semiconductor substrate, a method for producing a hybrid IC, and a nitride semiconductor substrate.

### BACKGROUND ART

As state-of-the-art devices made of silicon (Si), FinFETs (Fin Field-Effect Transistors) or GAA (Gate-All-Around) are fabricated on Si (110) substrates, which exhibit increased positive hole mobility, enabling the fabrication of such devices. Meanwhile, when forming GaN on the Si substrates (GaN on Si), gallium nitride (GaN) is epitaxially grown on Si (111) substrates, typically having a matched crystal structure and small lattice mismatch with GaN. Such GaN is used for producing power devices and light-emitting devices.

Patent Document 1 discloses the invention regarding a nitride semiconductor wafer and a method for producing a nitride semiconductor wafer. In Patent Document 1, it is disclosed that a plane orientation of a major surface of a high-resistivity, low-oxygen CZ silicon single-crystal substrate can be (100), (110), (111), or the like. As an Example, it is disclosed that a nitride semiconductor was epitaxially grown on a silicon single-crystal substrate with axis orientation of <111>.

### CITATION LIST

### PATENT LITERATURE

Patent Document 1: JP 2022-25512 A

### SUMMARY OF INVENTION

### TECHNICAL PROBLEM

When the present inventors actually investigated epitaxial growth of gallium nitride on a Si (110) substrate, it was found that the epitaxial growth of an initial AlN layer, a strain relaxation layer, and a GaN layer on a Si (110) substrate formed unevenness on a surface, resulting in poor morphology, which rendered the substrate unsuitable for device production. When the Si(110) substrate was employed, it was found that the surface morphology (flatness or roughness) of the gallium nitride epitaxial layer was degraded compared to growth on a Si (111) substrate. Accordingly, in a production of devices employing a GaN-on-Si substrate, even when a silicon substrate having a plane orientation of {110} on a major surface is employed, a nitride semiconductor substrate (GaN on Si(110)) provided with a gallium nitride epitaxial layer having an improved unevenness and excellent surface morphology on an epitaxial layer surface, along with a method for producing such a nitride semiconductor substrate are required.

In addition, when producing group III-nitride-based devices on the silicon substrates in the way described above, epitaxial growth on the Si (111) substrates is preferred from a viewpoint of quality of a GaN (group III-nitride) layer. On the other hand, for producing state-of-the-art Si devices (such as FinFET or GAA) on the silicon substrates, it is preferable to use the Si

(110) substrates. However, when producing a hybrid IC in which a silicon-based device and a group III-nitride-based device coexist on the same silicon substrate, the silicon-based device and the group III-nitride-based device are required to be formed on the silicon substrate having the same plane orientation with both devices.

Accordingly, when a technique to form a high-quality gallium nitride epitaxial layer on the Si (110) substrate (i.e., GaN on Si(110)) can be established, the group III-nitride-based device and the silicon-based device, such as FinFET or GAA, can be fabricated on the same Si (110) substrate, thereby enabling the production of the hybrid IC. Thus, a method for producing a hybrid IC is desired, in which the silicon substrate (Si {110} substrate) having a plane orientation of {110} on the major surface thereof is employed, and the hybrid IC is provided with the group III-nitride-based device, including the gallium nitride epitaxial layer with excellent surface morphology, and the silicon-based device.

The present invention has been made in view of the above-described problem. An object of the present invention is to provide: the nitride semiconductor substrate in which the silicon substrate having a plane orientation of {110} on the major surface is employed and the gallium nitride epitaxial layer having excellent surface morphology is provided thereon; the method for producing such a nitride semiconductor substrate; and the method for producing a hybrid IC, in which the silicon substrate having a plane orientation of {110} on the major surface thereof is employed, and the group III-nitride-based device, including the gallium nitride epitaxial layer with excellent surface morphology, and the silicon-based device are both provided thereon.

### SOLUTION TO PROBLEM

To achieve the object, the present invention provides a method for producing a nitride semiconductor substrate, the nitride semiconductor substrate comprising a group III-nitride layer that includes a group III-nitride base layer and a gallium nitride epitaxial layer on a silicon substrate, wherein
a silicon substrate having a plane orientation of {110} on a major surface thereof is employed, and the method comprises the steps of:
performing a pre-flow by supplying a gas containing an aluminum raw material and not containing a nitrogen raw material onto the silicon substrate being heated to a temperature of 1000°C or higher;
forming a base layer to form a group III-nitride base layer on the silicon substrate by supplying a gas containing a group III raw material and the nitrogen raw material; and
forming an epitaxial layer to form a gallium nitride epitaxial layer by supplying a gas containing a gallium raw material and the nitrogen raw material.

According to such a method for producing a nitride semiconductor substrate, it is possible to produce the nitride semiconductor substrate that is provided with the gallium nitride epitaxial layer having excellent surface morphology, even when the silicon substrate having a plane orientation of {110} on the major surface thereof is employed.

In this case, the method for producing a nitride semiconductor substrate, wherein an organic aluminum compound is used as the aluminum raw material, can be employed.

Accordingly, a lower-cost method for producing a nitride semiconductor substrate can be provided.

In this case, the method for producing a nitride semiconductor substrate, wherein the temperature to which the silicon substrate is heated in the step of performing a pre-flow is 1200°C or lower, can be employed.

Accordingly, the more stable step of performing a pre-flow can be performed.

The present invention also provides a method for producing a hybrid IC, the hybrid IC comprising a silicon-based device and a group III-nitride-based device coexisting on a same silicon substrate, wherein a silicon substrate having a plane orientation of {110} on a major surface thereof is employed, a mask having a first opening is formed in a region on the silicon substrate where the group III-nitride-based device is to be provided, and the method comprises the steps of:
performing a pre-flow by supplying a gas containing an aluminum raw material and not containing a nitrogen raw material onto the silicon substrate being heated to a temperature of 1000°C or higher;
forming a base layer to form a group III-nitride base layer on the silicon substrate by supplying a gas containing a group III raw material and the nitrogen raw material; and
forming an epitaxial layer to form a gallium nitride epitaxial layer by supplying a gas containing a gallium raw material and the nitrogen raw material, thereby providing the group III-nitride-based device to the first opening, wherein
thereafter, the mask in a region where the silicon-based device is to be provided is removed to form a second opening, thereby providing the silicon-based device in the second opening.

According to such a method for producing a hybrid IC, even when the silicon substrate having a plane orientation of {110} on the major surface thereof is employed, the hybrid IC provided with the group III-nitride-based device, including the gallium nitride epitaxial layer with excellent surface morphology, and the silicon-based device, can be produced.

In this case, the method for producing a hybrid IC, wherein an organic aluminum compound is used as the aluminum raw material, can be employed.

Accordingly, a lower-cost method for producing a hybrid IC can be provided.

In this case, the method for producing a hybrid IC, wherein the temperature to which the silicon substrate is heated in the step of performing a pre-flow is 1200°C or lower, can be employed.

Accordingly, the more stable step of performing a pre-flow can be performed.

To achieve the object, the present invention provides a nitride semiconductor substrate comprising a group III-nitride layer on a silicon substrate, wherein
the silicon substrate has a plane orientation of {110} on a major surface thereof,
the group III-nitride layer on the silicon substrate comprises a group III-nitride base layer and a gallium nitride epitaxial layer on the group III-nitride base layer, and
a surface roughness Ra on the gallium nitride epitaxial layer is 2.00 nm or less.

According to such a nitride semiconductor substrate, even when the silicon substrate having a plane orientation of {110} on the major surface thereof is employed, the nitride semiconductor substrate having excellent surface morphology, and suitable for a group III-nitride-based device, is obtained.

### ADVANTAGEOUS EFFECTS OF INVENTION

As described above, according to the inventive method for producing a nitride semiconductor substrate, even when the silicon substrate having a plane orientation of (110) on the major surface thereof is employed, the nitride semiconductor substrate provided with the gallium nitride epitaxial layer having excellent surface morphology can be produced. According to the inventive method for producing a hybrid IC, even when the silicon substrate having a plane orientation of {110} on the major surface thereof is employed, a hybrid IC provided with the group III-nitride-based device, including the gallium nitride epitaxial layer with excellent surface morphology, and the silicon-based device, can be produced. According to the inventive nitride semiconductor substrate, even when the silicon substrate having a plane orientation of {110} on the major surface thereof is employed, the nitride semiconductor substrate having excellent surface morphology, and suitable for a group III-nitride-based device, is obtained.

### BRIEF DESCRIPTION OF DRAWINGS

[FIG. 1] is a concrete example of a nitride semiconductor substrate according to the present invention.
[FIG. 2] is a flowchart of a method for producing a nitride semiconductor substrate and a method for producing a hybrid IC according to the present invention.
[FIG. 3] shows a comparison between surface morphologies of respective gallium nitride epitaxial layers on nitride semiconductor substrates in Example and Comparative Example.

### DESCRIPTION OF EMBODIMENTS

Hereinafter, the present invention will be described in detail. However, the present invention is not limited thereto.

As described above, the following are desired: a nitride semiconductor substrate, in which a silicon substrate having a plane orientation of {110} on a major surface thereof is employed, and a gallium nitride epitaxial layer having excellent surface morphology is provided; a method for producing such a nitride semiconductor substrate; and a method for producing a hybrid IC, in which a silicon substrate having a plane orientation of {110} on a major surface thereof is employed, and a group III-nitride-based device, including a gallium nitride epitaxial layer with excellent surface morphology, and a silicon-based device are provided.

To solve the above problem, the present inventors have earnestly studied and found out that a method for producing a nitride semiconductor substrate, the nitride semiconductor substrate including a group III-nitride layer that includes a group III-nitride base layer and a gallium nitride epitaxial layer on a silicon substrate, in which a silicon substrate having a plane orientation of {110} on a major surface thereof is employed, and the method includes the steps of performing a pre-flow by supplying a gas containing an aluminum raw material and not containing a nitrogen raw material onto the silicon substrate being heated to a temperature of 1000°C or higher, forming a base layer to form a group III-nitride base layer on the silicon substrate by supplying a gas containing a group III raw material and the nitrogen raw material, and forming an epitaxial layer to form a gallium nitride epitaxial layer by supplying a gas containing a gallium raw material and the nitrogen raw material; consequently, the present inventors found that it is possible to produce a nitride semiconductor substrate that is provided with the gallium nitride epitaxial layer having excellent surface morphology, even when the silicon substrate having a plane orientation of {110} on the major surface thereof is employed. This finding has led to the completion of the present invention.

To solve the above problem, the present inventors have earnestly studied and found out that a method for producing a hybrid IC, the hybrid IC including a silicon-based device and a group III-nitride-based device coexisting on a same silicon substrate, in which a silicon substrate having a plane orientation of {110} on a major surface thereof is employed, a mask having a first opening is formed in a region on the silicon substrate where the group III-nitride-based device is to be provided, and the method includes the steps of performing a pre-flow by supplying a gas containing an aluminum raw material and not containing a nitrogen raw material onto the silicon substrate being heated to a temperature of 1000°C or higher, forming a base layer to form a group III-nitride base layer on the silicon substrate by supplying a gas containing a group III raw material and the nitrogen raw material, and forming an epitaxial layer to form a gallium nitride epitaxial layer by supplying a gas containing a gallium raw material and the nitrogen raw material, thereby providing the group III-nitride-based device to the first opening, in which thereafter, the mask in a region where the silicon-based device is to be provided is removed to form a second opening, thereby providing the silicon-based device in the second opening; consequently, the present inventors found that it is possible to produce a hybrid IC provided with the group III-nitride-based device, including the gallium nitride epitaxial layer with excellent surface morphology, and the silicon-based device, even when the silicon substrate having a plane orientation of {110} on the major surface thereof is employed. This finding has led to the completion of the present invention.

To solve the above problem, the present inventors have earnestly studied and found out that a nitride semiconductor substrate including a group III-nitride layer on a silicon substrate, in which the silicon substrate has a plane orientation of {110} on a major surface thereof, the group III-nitride layer on the silicon substrate includes a group III-nitride base layer and a gallium nitride epitaxial layer on the group III-nitride base layer, and a surface roughness Ra on the gallium nitride epitaxial layer is 2.00 nm or less; consequently, the present inventors found that even when the silicon substrate having a plane orientation of {110} on the major surface thereof is employed, the nitride semiconductor substrate having excellent surface morphology, and suitable for a group III-nitride-based device, is obtained. This finding has led to the completion of the present invention.

Hereinafter, the description will be given with reference to the drawings.

### [Nitride Semiconductor Substrate]

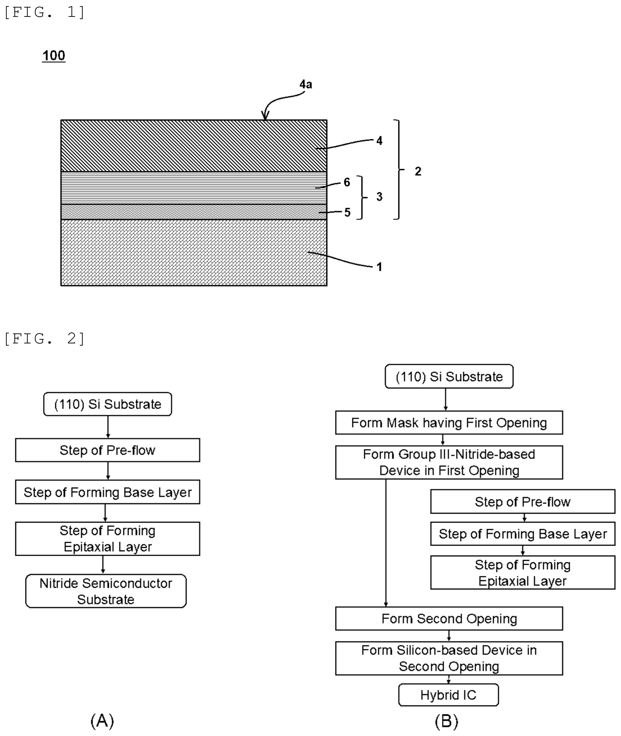

The nitride semiconductor substrate according to the present invention will be described with reference to FIG. 1. A nitride semiconductor substrate 100 according to the present invention is provided with a silicon substrate 1 and a group III-nitride layer 2 on the silicon substrate 1.

The silicon substrate 1 employed herein has a major surface with a plane orientation of {110}. The silicon substrate 1 is not particularly limited as long as the major surface has a plane orientation of {110}. A shape of the substrate (circular, rectangular, or the like), a dimension thereof (thickness, diameter, or the like), an oxygen concentration thereof, resistivity thereof (dopant concentration), and a method for producing a silicon substrate (CZ, FZ) are not particularly limited, and can be appropriately set according to a final design of the group III-nitride-based device. Note that in this description, the plane orientation {110} includes planes equivalent to (110). In addition, "a plane orientation of {110} on the major surface" includes a plane orientation on a major surface having no miscut (off-angle=0°) with respect to that of {110}, but also a major surface having an off-angle within a range of ±8° with respect to that of {110}.

The group III-nitride layer 2 on the silicon substrate 1 is provided with a group III-nitride base layer 3 and a gallium nitride epitaxial layer 4 on the group III-nitride base layer 3. In addition, a roughness Ra on a surface 4a on the gallium nitride epitaxial layer 4 is 2.00 nm or less. Note that the gallium nitride epitaxial layer 4 may be composed of a plurality of gallium nitride epitaxial layers having different types and concentrations of dopants. Moreover, a thickness of the gallium nitride epitaxial layer 4 is not particularly limited, but, for example, can be 0.8 µm or more and 10 µm or less. When the thickness is within such a range, the gallium nitride epitaxial layer having the surface roughness Ra of 2.00 nm or less can be stably obtained. Note that the lower limit of the roughness Ra of the surface 4a on the gallium nitride epitaxial layer 4 is 0.00 nm or more.

The group III-nitride base layer 3 may further include, for example, an initial layer 5 such as AlN on a surface of the silicon substrate 1, or a buffer layer 6 such as a gradient composition layer, or a superlattice layer.

Even when using the silicon substrate 1 having a plane orientation of {110} on the major surface thereof, the nitride semiconductor substrate according to the present invention has the surface 4a of the gallium nitride epitaxial layer 4 with the roughness Ra of 2.00 nm or less, thereby exhibiting excellent flat surface morphology. This results in the nitride semiconductor substrate being suitable for the group III-nitride-based device.

### [Method for Producing Nitride Semiconductor Substrate]

Next, the method for producing a nitride semiconductor substrate according to the present invention will be described with reference to FIG. 2(A). The method for producing a nitride semiconductor substrate according to the present invention is a method for producing a nitride semiconductor substrate 100 that is provided with the group III-nitride layer 2, including the group III-nitride base layer 3 on the silicon substrate 1 and the gallium nitride epitaxial layer 4.

The method for producing a nitride semiconductor substrate according to the present invention, in which the silicon substrate 1 having a plane orientation of {110} on a major surface thereof is employed, includes the steps of performing a pre-flow by supplying a gas containing an aluminum raw material and not containing a nitrogen raw material onto the silicon substrate 1 heated to a temperature of 1000°C or higher, forming a base layer to form the group III-nitride base layer 3 on the silicon substrate 1 by supplying a gas containing a group III raw material and the nitrogen raw material, and forming an epitaxial layer to form the gallium nitride epitaxial layer 4 by supplying a gas containing a gallium raw material and the nitrogen raw material. Hereinafter, each step will be described.

### [Step of Performing Pre-flow]

This step can be performed within a film-forming apparatus in which the subsequent step of forming a base layer or the subsequent step of forming an epitaxial layer is performed. The silicon substrate 1, having a plane orientation of {110} on the major surface thereof, is heated to a temperature of 1000°C or higher, and a gas containing the aluminum raw material and not containing the nitrogen raw material is supplied on the substrate 1. When the nitrogen raw material is contained, the formation of AlN is concerned, which inhibits surface treatment of the silicon substrate 1 with the aluminum raw material before the base layer formation, and fails to produce a flattening effect on the surface of the gallium nitride epitaxial layer 4.

The temperature for heating the silicon substrate 1 may be 1000°C or higher, and the upper limit from a technical standpoint is lower than a melting point of the silicon substrate 1, but preferably 1200°C or lower. While an excessively high temperature produces no significant difference in the effect of the pre-flow step, the temperature of 1200°C or lower may be sufficient in view of stability or productivity of the pre-flow treatment, because damage to the Si substrate or a member of the film-forming apparatus can be more stably suppressed.

Duration for supplying the gas containing the aluminum raw material and not containing the nitrogen raw material is not particularly limited. The lower limit thereof can be, for example, 1 second or more, preferably 3 seconds or more, and more preferably 5 seconds or more. The upper limit can be, for example, 60 seconds or less, preferably 30 seconds or less, and more preferably 15 seconds or less. Within such a range, the flattening effect on the surface of the gallium nitride epitaxial layer 4 can be more stably obtained.

The gas containing the aluminum raw material and not containing the nitrogen raw material, which is used in the step of performing a pre-flow, is not particularly limited. It is preferable to use an organic aluminum compound as the aluminum raw material. Concrete examples of the organic aluminum compound include trimethylaluminum (TMA), triethylaluminum (TEA), or the like. These compounds are used as the raw materials for film-forming of the group III-nitride. When the organic aluminum compound is used in the subsequent step of forming a base layer, or the like, the same gas can be used, thus suitable in terms of cost and in preventing contamination of the substrate and growth apparatus. In addition, hydrogen (H₂) gas can be used as a carrier gas.

The present inventors investigated a cause by which the pre-flow step enables the surface roughness Ra on the surface of the gallium nitride epitaxial layer to have 2.00 nm or less, and makes the surface thereof a mirror surface. However, even when an attempt was made to analyze the substrate immediately after the pre-flow step, it was impossible to clearly determine the differences in the silicon substrate surface structure depending on the presence or absence of the pre-flow step. This is presumed to be caused by a modification of an Al layer prior to the analysis, where the layer is considered to form in an extremely thin manner. It is also attributed to a change in the silicon substrate surface structure, which is affected by the pre-flow step induced by thermal treatment during the subsequent steps, immediately after the production of the nitride semiconductor substrate. In this way, although a reason for the mirror surface having the roughness Ra of 2.00 nm or less on the surface of the gallium nitride epitaxial layer generated by performing a pre-flow step is not clear, one possible explanation is that the extremely thin Al layer having approximately several angstroms is formed by the step of performing a pre-flow, an eutectic reaction with Si induces a formation of fine surface unevenness, which exposes a {111} plane, and a lateral growth of the group III-nitride layer, such as GaN, is facilitated. In any case, by conducting the step of performing a pre-flow according to the present invention, the surface roughness Ra on the surface of the gallium nitride epitaxial layer can be reduced to 2.00 nm or less, thereby enabling the formation of the mirror surface.

Note that it is preferable that the silicon substrate surface is subjected to baking (thermal treatment) in a hydrogen (H₂) gas atmosphere prior to the step of performing a pre-flow to clean the silicon substrate surface. However, when the silicon substrate surface is in a clean state, the cleaning is not always essential.

### (Step of Forming Base Layer)

Next, the step of forming a base layer will be described. Following the step of performing a pre-flow described above, the gas containing the group III raw material and the nitrogen raw material is supplied to form the group III-nitride base layer 3, which is a part of the group III-nitride layer 2, on the silicon substrate 1. As the group III-nitride base layer 3, it is possible to form the initial layer 5, such as AlN, or the buffer layer 6, such as the gradient composition layer, or the superlattice layer. The conditions for forming the group III-nitride base layer 3 are not particularly limited.

### (Step of Forming Epitaxial Layer)

Subsequent to the step of forming a base layer, the step of forming an epitaxial layer is conducted, in which the gas containing the gallium raw material and the nitrogen raw material is supplied to form the gallium nitride epitaxial layer 4. The conditions for forming the gallium nitride epitaxial layer 4 are not particularly limited. For example, the gallium nitride epitaxial layer 4 may be formed using an MOCVD method, an HVPE method, or the like. As the gallium raw material, organogallium compounds, such as trimethylgallium (TMG), triethylgallium (TEG), or the like, can be used. Note that a plurality of gallium nitride epitaxial layers with varying types and concentrations of the dopant may be formed as the gallium nitride epitaxial layer 4.

### [Method for Producing Hybrid IC]

Next, the method for producing a hybrid IC according to the present invention will be described with reference to FIG. 2(B). In the method for producing a hybrid IC according to the present invention, the silicon substrate having a plane orientation of {110} on the major surface thereof is employed. Subsequently, the mask having the first opening is formed on this silicon substrate, and the group III-nitride-based device, such as an electronic device, a light-emitting device, or the like, is then provided in the first opening. Thereafter, the mask in the region where the silicon-based device is to be provided is removed to form the second opening, thereby providing the silicon-based device in the second opening. As a result, it is possible to produce a hybrid IC including the group III-nitride-based device and the silicon-based device coexisting on a <110> silicon substrate exhibiting improved positive hole mobility, in which the group III-nitride-based device is provided with the gallium nitride epitaxial layer having the mirror surface with excellent surface morphology, and the silicon-based device includes FinFET (Fin Field-Effect Transistor), GAA(Gate-All-Around), or the like.

### (Forming Group III-nitride-based Device)

In the formation of the group III-nitride-based device in the method for producing a hybrid IC according to the present invention, the group III-nitride-based device is formed in the first opening. In addition, in the formation of the group III-nitride-based device, "the step of performing a pre-flow", "the step of forming a base layer", and "the step of forming an epitaxial layer" are performed as described in the method for producing a nitride semiconductor substrate. Description regarding details of respective steps is omitted as the description is identical to that of the method for producing a nitride semiconductor substrate.

### (Forming Silicon-based Device)

In the formation of the silicon-based device in the method for producing a hybrid IC according to the present invention, the silicon-based device is formed in the second opening. Although the silicon-based device is not particularly limited, it is preferable to fabricate FinFET or GAA to take advantage of benefit of using the Si {110} substrate.

In this way, the hybrid IC where the silicon-based device and the group III-nitride-based device coexist on the same substrate can be produced.

### (First Embodiment)

Hereinafter, a concrete example of a method for producing a nitride semiconductor substrate according to the present invention is described as the first embodiment. First, a Si (110) substrate is provided. Substrate surface cleaning by hydrogen (H₂) bake is performed halfway through a temperature rise of the Si substrate to a growth temperature. Subsequently, before initiating growth of an initial AlN layer, a pre-flow using TMA is performed, for example, within 60 seconds. Subsequently, the initial AlN layer and a buffer layer composed of an AlₓGa₁₋ₓN (x≥0) layer is formed, followed by forming an island-shaped SiN layer, and a GaN layer is then stacked. When used in an electronic device, an AlGaN layer is formed on the GaN layer to produce a HEMT structure. When used in a light-emitting device, an MQW structure composed of GaN/InGaN is produced on the buffer layer, which is the AlₓGa₁₋ₓN (x≥0) layer, and p-GaN is then formed to produce the light-emitting device. Note that the buffer layer described above may have a compositional change in a graded manner or may be composed of a plurality of layers having different compositions. For example, the buffer layer may be a step-graded AlGaN layer, a superlattice AlGaN/GaN, a superlattice AlN/GaN, or an intermittent superlattice structure.

A more specific example, along with conditions for the production, is described. Halfway through the temperature rise of the Si substrate to the growth temperature (1000 to 1200°C), nitrogen (N₂) gas is switched to hydrogen (H₂) gas, and the substrate surface is cleaned by the hydrogen (H₂) bake while raising the temperature. Thereafter, the pre-flow step is performed by supplying TMA at a temperature of 1000 to 1200°C. Next, by supplying TMA+NH₃ gas to the Si substrate, the initial AlN layer having a thickness of 100 to 200 nm is formed, and by supplying TMA+TMG (trimethylgallium) +NH₃ gas, the buffer layer of the AlGaN layer having a thickness of 100 to 200 nm is formed. The supply of TMA and TMG is then interrupted, and SiH₄+NH₃ is supplied to form the island-shaped SiN layer. The supply of monosilane gas is stopped, and TMG is then introduced to grow the GaN layer for 15 to 50 nm. Subsequently, the superlattice (SLs) buffer layer composed of 15 to 25 pairs of AlN/GaN is formed. Thereafter, the GaN layer, having a thickness of approximately 800 to 900 nm, is formed to obtain the nitride semiconductor substrate.

### (Second Embodiment)

Hereinafter, a concrete example of a method for producing a hybrid IC according to the present invention is described as the second embodiment. First, a Si (110) substrate is provided. A thermal oxide film having a thickness of approximately 100 nm is formed on the Si substrate surface. A mask is formed by employing photolithography in a portion where a Si device is to be fabricated, and an oxide film in a portion where a gallium nitride epitaxial layer is grown is removed by dry etching to expose only a portion of the Si substrate where a group III-nitride-based device is to be fabricated (first opening). Subsequent fabrication of the group III-nitride-based device is identical to that of the first embodiment.

After fabricating the group III-nitride-based device, a group III-nitride-based (GaN) device portion is protected, and a GaN film is removed by dry etching, in which the GaN film is poly-grown on an oxide film on a portion where a silicon-based device is to be fabricated. When the poly-GaN film is removed to expose an oxide film layer, the resulting Si substrate is immersed in a HF solution to remove the oxide film layer, thereby exposing the Si substrate (second opening). The silicon-based device is fabricated on the exposed Si substrate.

### EXAMPLE

Hereinafter, the present invention will be specifically described with reference to Example. However, the present invention is not limited thereto.

### (Example)

As a substrate for epitaxial growth for GaN on Si, a Si (110) substrate having a diameter of 150 mm, p-type (boron concentration of 6×10¹⁴ atoms/cm³ or less), and an oxygen concentration of 7×10¹⁷ atoms/cm³ was provided. The Si (110) substrate was loaded into an MOCVD apparatus, and hydrogen was used as a carrier gas. When epitaxial growth temperature reached 1150°C, a pre-flow using TMA (trimethylaluminum) was performed for 6 seconds. Subsequently, ammonia gas, which is a nitrogen source, was introduced to form an initial AlN layer of 150 nm, and TMG (trimethylgallium) was then introduced to form an AlGaN layer of 160 nm. The supply of TMA and TMG was interrupted, and monosilane gas was introduced to grow an island-shaped SiN layer of 1 nm. The supply of monosilane gas was stopped, and TMG was introduced to grow a GaN layer of 25 nm. On top of the laminate, a buffer layer having a thickness of 400 nm was formed with an SLs structure composed of 23 pairs of an AlN layer of 4.2 nm and a GaN layer of 25 nm. Further, on top of that, a GaN layer of 820 nm was grown to form a gallium nitride epitaxial layer.

### (Comparative Example)

A gallium nitride epitaxial layer was formed in the same steps and conditions as in Example, except that a pre-flow using TMA was not performed.

### (Evaluation)

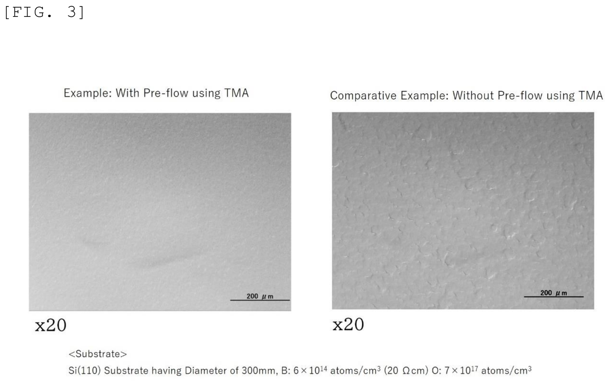

First, an evaluation of the surface morphology of the gallium nitride epitaxial layer was performed. Specifically, an evaluation of the presence or absence of cloudiness by visual observation using a collimated light, and an observation using a differential interference microscope were performed. As a result of the collimated light observation, cloudiness was observed on the surface of the gallium nitride epitaxial layer in Comparative Example. In contrast, cloudiness was not observed on the gallium nitride epitaxial layer surface in Example, where it was found that the surface was a mirror surface. In addition, as a result of the observation using the differential interference microscope, as shown in FIG. 3, unevenness was observed on the gallium nitride epitaxial layer surface in Comparative Example; in contrast, the gallium nitride epitaxial layer surface was found to be smooth in Example. In addition, when surface roughness of the gallium nitride epitaxial layer surface was measured using a probe type profiler (P-15 manufactured by KLA-Tencor Corporation), Ra was 1.86 nm in Example, and Ra was 12.5 nm in Comparative Example. According to Example of the present application, the gallium nitride epitaxial layer, having a surface roughness Ra of 2.00nm or less and the mirror surface, was successfully obtained.

In addition, when XRD evaluation was performed as an evaluation of crystalline, only (002) and (004) diffraction peaks were detected in the gallium nitride epitaxial layers in both Example and Comparative Example, indicating that (001) planes were aligned in a normal surface direction. Moreover, a half-value width of a rocking curve of GaN (002) was 197 arcsec in Example, and 211 arcsec in Comparative Example. It was found that the gallium nitride epitaxial layers having equivalent crystalline were obtained in both Example and Comparative Example.

As shown above, according to Example of the present invention, the nitride semiconductor substrate provided with the gallium nitride epitaxial layer was successfully produced, in which the gallium nitride epitaxial layer had a surface with the surface roughness Ra of 2.00 nm or less, indicating that the surface was flat and had excellent surface morphology.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a nitride semiconductor substrate, the nitride semiconductor substrate comprising a group III-nitride layer that includes a group III-nitride base layer and a gallium nitride epitaxial layer on a silicon substrate, wherein
a silicon substrate having a plane orientation of {110} on a major surface thereof is employed, and the method comprises the steps of:
performing a pre-flow by supplying a gas containing an aluminum raw material and not containing a nitrogen raw material onto the silicon substrate being heated to a temperature of 1000°C or higher;
forming a base layer to form a group III-nitride base layer on the silicon substrate by supplying a gas containing a group III raw material and the nitrogen raw material; and
forming an epitaxial layer to form a gallium nitride epitaxial layer by supplying a gas containing a gallium raw material and the nitrogen raw material.

2. The method for producing a nitride semiconductor substrate according to claim 1, wherein
an organic aluminum compound is used as the aluminum raw material.

3. The method for producing a nitride semiconductor substrate according to claim 1 or 2, wherein
the temperature to which the silicon substrate is heated in the step of performing a pre-flow is 1200°C or lower.

4. A method for producing a hybrid IC, the hybrid IC comprising a silicon-based device and a group III-nitride-based device coexisting on a same silicon substrate, wherein
a silicon substrate having a plane orientation of {110} on a major surface thereof is employed, a mask having a first opening is formed in a region on the silicon substrate where the group III-nitride-based device is to be provided, and the method comprises the steps of:
performing a pre-flow by supplying a gas containing an aluminum raw material and not containing a nitrogen raw material onto the silicon substrate being heated to a temperature of 1000°C or higher;
forming a base layer to form a group III-nitride base layer on the silicon substrate by supplying a gas containing a group III raw material and the nitrogen raw material; and
forming an epitaxial layer to form a gallium nitride epitaxial layer by supplying a gas containing a gallium raw material and the nitrogen raw material, thereby providing the group III-nitride-based device to the first opening, wherein
thereafter, the mask in a region where the silicon-based device is to be provided is removed to form a second opening, thereby providing the silicon-based device in the second opening.

5. The method for producing a hybrid IC according to claim 4, wherein
an organic aluminum compound is used as the aluminum raw material.

6. The method for producing a hybrid IC according to claim 4 or 5, wherein
the temperature to which the silicon substrate is heated in the step of performing a pre-flow is 1200°C or lower.

7. A nitride semiconductor substrate comprising a group III-nitride layer on a silicon substrate, wherein
the silicon substrate has a plane orientation of {110} on a major surface thereof,
the group III-nitride layer on the silicon substrate comprises a group III-nitride base layer and a gallium nitride epitaxial layer on the group III-nitride base layer, and
a surface roughness Ra on the gallium nitride epitaxial layer is 2.00 nm or less.
